# EUROPÄISCHE PATENTSCHRIFT

(11) **EP 2 086 020 B1**
(45) Veröffentlichungstag und Bekanntmachung des Hinweises auf die Patenterteilung: **04.12.2013**
(21) Anmeldenummer: 08018011.0
(22) Anmeldetag: 15.10.2008
(51) Int. Cl.: H01L 31/042, H01L 31/02

(54) **Photovoltaik-Anlage mit Potentialanhebung**
Photovoltaic assembly with potential increase
Installation photovoltaïque comportant une hausse de potentiel

(30) Priorität: 23.10.2007 DE 102007050554
(43) Veröffentlichungstag der Anmeldung: 05.08.2009
(73) Patentinhaber: Padcon GmbH, 97318 Kitzingen (DE)
(72) Erfinder: Beck, Bernhard, 97323 Volkach OT Dimbach (DE); Müller, Tim, 01458 Ottendorf-Okrilla (DE)

(56) Entgegenhaltungen:
- DE-A1- 2 903 559
- DE-A1-102006 014 780
- DE-U1-202006 008 936
- US-A1- 2004 165 408
- US-A1- 2005 121 067

## Beschreibung

Die Erfindung bezieht sich auf eine Photovoltaikanlage mit einer Mehrzahl von Photovoltaik-Modulen, die elektrisch zu einem Photovoltaik-Generator verbunden sind, dessen erstes Strangende einen Minuspol bildet und dessen zweites Strangende einen Pluspol bildet. Der Photovoltaik-Generator umfasst dabei eine Zahl von Photovoltaik-Modulen, die zu mindestens einem Strang verbunden sind. Es können auch mehrere parallel geschaltete Stränge vorgesehen sein.

Anlagen dieser Art sind sattsam bekannt. In solchen Anlagen ist eine Anzahl von z.B. zehn Photovoltaik-Modulen in Reihe geschaltet. Die Module bilden dabei einen sogenannten Strang. Jedes Photovoltaik-Modul umfasst wiederum z. B. 100 Photovoltaikzellen, die ihrerseits elektrisch in Reihe geschaltet sind. Die einzelne Photovoltaikzelle erzeugt bei Einstrahlung von Sonnenenergie eine Spannung von ca. 0,5 Volt. Im Ergebnis liegt dann je nach Einsatz der Anlage im Lastfall über den Strang eine Spannung, im folgenden Strangspannung genannt, von ca. 500 Volt vor. Im Folgenden wird beispielhaft von einer Strangspannung unter Last von ca. 500 Volt und im Leerlauffall von ca. 800 Volt ausgegangen. Es ist üblich, eine Mehrzahl von Strängen, z.B. von 10 Strängen, durch Parallelschalten zu bündeln und dann die erzeugte Energie mittels einer gemeinsamen Sammelleitung zur weiteren Verwertung bereitzustellen.

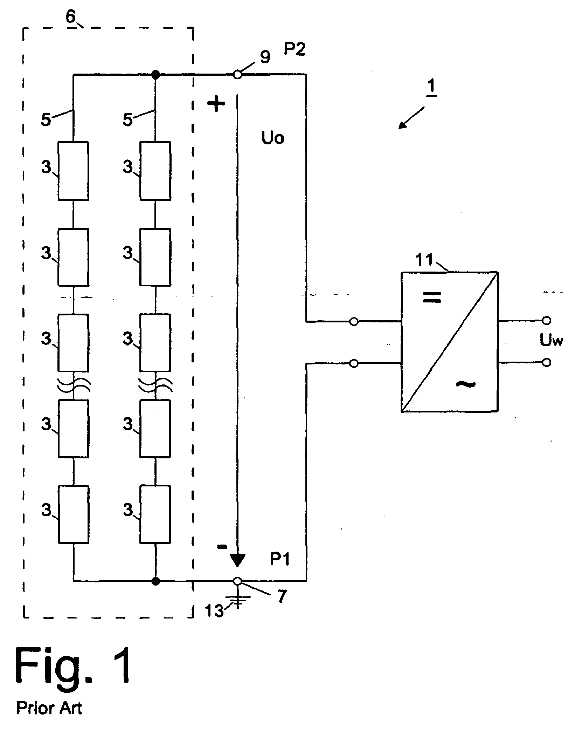

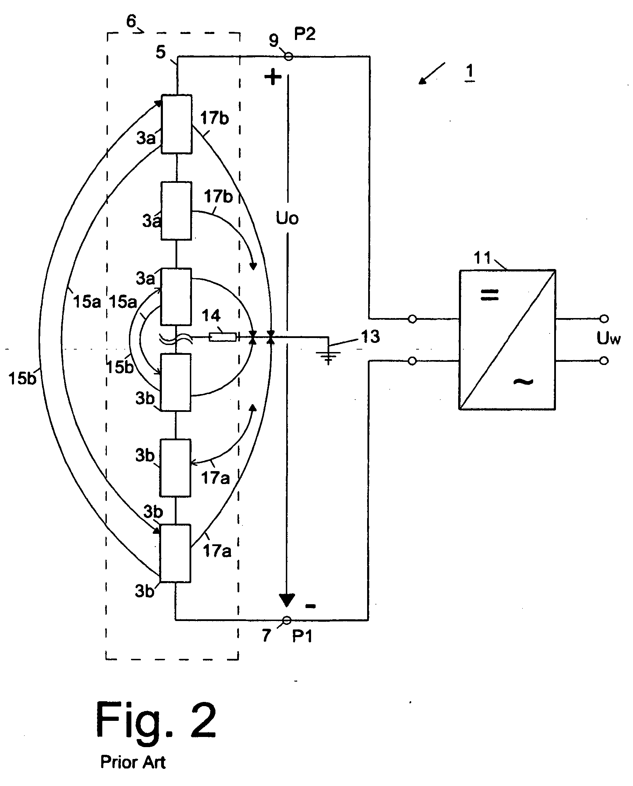

Die erzeugte elektrische Energie liegt in Form einer Gleichspannung vor. Sie wird mittels eines Wechselrichters in eine Wechselspannung wechselgerichtet. Dabei sind zurzeit die in den Figuren 1 und 2 beispielhaft gezeigten Schaltungen üblich. Gleiche Bauelemente sind jeweils mit denselben Bezugszeichen versehen.

Nach Fig. 1 umfasst eine Photovoltaikanlage 1 eine Anzahl von Photovoltaik-Elementen 3, die jeweils in Reihe geschaltet sind und hier zwei Stränge 5 bilden, die parallel zu einander geschaltet sind. Der so gebildete Photovoltaik-Generator 6 besitzt ein erstes und ein zweites Strangende 7, 9, die negatives bzw. positives Potential P1 bzw. P2 aufweisen. Das erste Strangende 7 ist der Minuspol des Photovoltaik-Generators 6 und besitzt damit das erste (niedere) Strangpotential P1, und das zweite Strangende 9 ist der Pluspol des Photovoltaik-Generators 6 und besitzt damit das zweite (höhere) Strangpotential P2. An die Strangenden 7, 9 ist ein Wechselrichter 11 angeschlossen. Die Spannung Uo zwischen den Strangenden 7, 9 beträgt im Lastfall z. B. die erwähnten ca. 500 V.

Gemäß Figur 1 wird die Photovoltaikanlage 1 potentialgebunden betrieben, d.h. das negative Strangpotential P1 wird auf Erde 13, d. h. an Erdpotential gelegt, und das positive Strangpotential P2 ist entsprechend der Anzahl der in Reihe geschalteten Photovoltaikzellen beider Stränge 5 ca. 500 Volt unter Last.

Der Grundnachteil dieser Schaltung nach Fig. 1 ist es, dass sie durch die Verbindung des Minuspols 7 mit der Erde 13 eine hohe Affinität besitzt, Blitze "anzuziehen". Es müssen daher umfangreiche Vorsorgemaßnahmen ergriffen werden, um einen Blitzeinschlag zu vermeiden. Denn dieser würde zu einer Zerstörung des Wechselrichters führen. Dies kann mit einem Schaden von mehreren 100.000 Euro bei größeren Anlagen verbunden sein. Alternativ können aufwändige Überspannungsableiter vorgesehen werden, die die Anlage 1 verteuern. Außerdem müssen die spannungsführenden Teile gut gegen Berührung gesichert sein. Es besteht die Gefahr eines Stromschlags, wenn eine auf dem Boden stehende Person Verbindungs- oder Leiterteile mit z. B. der maximalen Strangspannung Uo berührt. Sämtliche in der Anlage 1 verbauten, nicht isolierten Teile müssten geerdet werden.

Es wurde nun erkannt, dass bei großen Anlagen 1 durchaus ein ganz geringer, immerhin messbarer Strom von den einzelnen Modulen 3 gegen Erde 13 fließen kann, und dass dennoch in den Modulen 3 auch nach längerem Normal-Betrieb keine nennenswerte Schädigung festgestellt wurde.

Die in Figur 2 gezeigte zweite Schaltung 1 umfasst, der einfachen Darstellung wegen, im Photovoltaik-Generator 6 nur einen Strang 5 aus in Reihe geschalteten Modulen 3. Diese Photovoltaikanlage 1 mildert die Gefahr des Blitzeinschlags und vermeidet die Gefahr eines Stromschlags für Personen, bringt dafür aber einen anderen Nachteil ins Spiel. Bei dem gezeigten sogenannten potentialfreien Betrieb der Photovoltaikanlage 1 liegt an jedem der beiden Strangenden 7, 9 betragsmäßig ungefähr die gleiche Spannung gegenüber Erde 13 an. Das positive Strangpotential P2 im Leerlauffall (Uo = 800V) beträgt am Beispiel betrachtet ca. + 400 Volt gegen Erde 13, und das negative Strangpotential P1 beträgt ca. - 400 Volt gegen Erde 13. Diese Spannungen gegenüber Erde 13 trotz potentialfreiem Betrieb kommen durch einen nicht zu vernachlässigenden relativ kleinen Leitwert (= Kehrwert des ohmschen Widerstands) der verhältnismäßig langen Verbindungsleitungen zwischen den Modulen 3 (Verdrahtung der Anlage 1) und der Zuleitungen zum Wechselrichter 11 zustande. In einer Ersatzschaltbilddarstellung ist der kleine Leitwert durch einen Widerstand 14 symbolisiert, der etwa der Mitte der Reihenschaltung 5 der Module 3 zur Erde 13 führt. Dadurch nehmen parasitäre Entladungen zur Erde 13 endlich große Ausmaße an, und es stellt sich o.g. Potentialverteilung + 400V, - 400V gegenüber Erde 13 ein, da sie für die Gesamtanlage 1 energetisch am günstigsten ist.

Das Dokument DE 202006008936 U1 offenbart eine Photovoltaikanlage mit einer Mehrzahl von Photovoltaik-Modulen, die elektrisch zu mindestens einem Strang verbunden sind und so einen Photovoltaik-Generator bilden, dessen erstes Strangende einen Minuspol bildet und dessen zweites Strangende einen Pluspol bildet, und mit einer Spannungsquelle zur Spannungsanhebung, mittels der das Potential des Pluspols gegenüber Erde angehoben wird, wobei die Spannungsquelle einen Minus-Anschlusspol und einen Plus-Anschlusspol aufweist, und wobei der Minus-Anschlusspol auf Erdpotential gelegt ist und der Plus-Anschlusspol elektrisch mit dem Minuspol des Photovoltaik-Generators verbunden ist.

Die Erfindung hat es sich zur Aufgabe gestellt, Sicherheit gegen Blitzeinschlag zu bewirken.

In einer Aufgestaltung soll ein Schutz von Personen vor elektrischem Schlag erreicht werden. In einer weiteren Ausführung soll die Erkennung von Diebstahl erreicht werden.

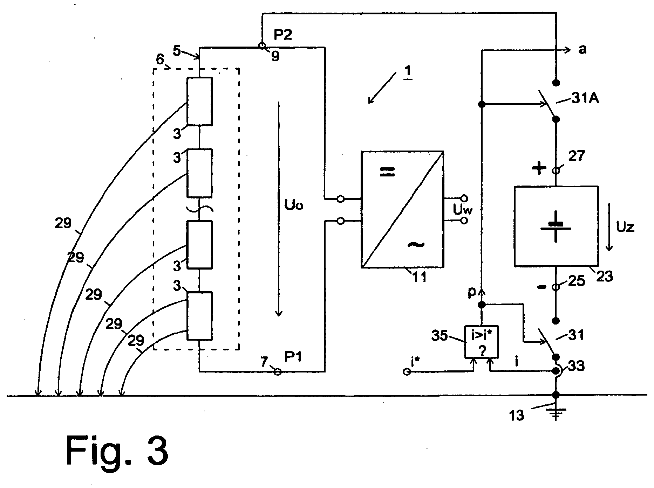

Die genannte Aufgabe wird erfindungsgemäß durch eine Photovoltaikanlage gelöst, die ausgestattet ist mit einer Mehrzahl von Photovoltaik-Modulen, die elektrisch zu mindestens einem Strang verbunden sind und so einen Photovoltaik-Generator bilden, dessen erstes Strangende einen Minuspol bildet und dessen zweites Strangende einen Pluspol bildet, und mit einer Vorrichtung zur Spannungsanhebung, mittels der das Potential des Pluspols gegenüber Erde angehoben wird, wobei die Vorrichtung eine Spannungsquelle mit einem Minus-Anschlusspol und einem Plus-Anschlusspol ist, und wobei der Minus-Anschlusspol auf Erdpotential gelegt ist und der Plus-Anschlusspol elektrisch
- mit dem Pluspol (Fig. 3)
   des Photovoltaik-Generators verbunden ist.

Hier wird also folgendermaßen vorgegangen:

Anstatt den Minuspol zu erden, wie im Stand der Technik nach Fig. 1 üblich, wird hier der Pluspol auf ein gewünschtes Niveau (z. B. auf 1000V) angehoben, und der Minuspol floatet entsprechend den Betriebsparametern des in der Regel angeschlossenen potentialfreien Wechselrichters.

Hier soll folgendes betont werden: Je näher sich ein spannungsführendes Element (Kabel, Photovoltaikmodul) am Erdpotential befindet, desto größer ist die Wahrscheinlichkeit eines Blitzeinschlags. Bei der Erfindung werden die spannungsführenden Elemente vergleichsweise auf ein höheres Potential geführt, so dass die Blitz-Einschlagsgefahr reduziert ist.

Als Spannungsquelle ist eine Konstant-Spannungsquelle vorgesehen. Allerdings kann auch prinzipiell eine Konstant-Gleichstromquelle eingesetzt werden. Diese kann einen Konstantstrom zwischen 0.5 mA und 1500 mA einprägen. Der über die Luft abdiffundierende Elektronenfluss liegt in der Größenordnung von 1 mA. Dieser Stromfluss wird von der Konstantstromquelle kompensiert.

Die Vorrichtung zur Spannungsanhebung ist also eine Konstant-Spannungsquelle mit einem Minus-Anschlusspol und einem Plus-Anschlusspol, wobei der Minus-Anschlusspol auf Erdpotential gelegt ist und der Plusanschlusspol elektrisch mit dem Pluspol des PV-Generators verbunden ist. Diese Maßnahme bietet den Vorteil, dass aufgrund des theoretisch unendlich hohen Innenwiderstands der Spannungsquelle die Eigenschaft der potentialfreien Variante erhalten bleibt, zusätzlich jedoch die Wahrscheinlichkeit eines Blitzeinschlags verringert wird.

Die Zusatzaufgabe des Schutzes von Personen vor elektrischem Schlag und die Erkennung von Diebstahl kann durch das Einprägen eines Signals auf einen Anschlusspol des Photovoltaikgenerators gelöst werden. Sofern ein Signal eingeprägt wird und ein entsprechender Empfänger ebenfalls angeschlossen ist, wird dieser eine Signatur des Photovoltaikgenerators empfangen. Wird zum Beispiel einer von mehreren Strängen aufgetrennt, so wird sich die Signatur des Photovoltaikgenerators ändern. Eine solche Änderung kann durch den Empfänger erkannt werden, und ein entsprechendes Signal kann an eine Diebstahlmeldezentrale weitergeleitet werden. Ebenso kann die Änderung der Signatur auch dadurch hervorgerufen werden, dass im Fehlerfall eine stromführende Leitung Kontakt zu einem leitenden Element, wie z. B. zu einem Metallträger, bekommt. Sofern dieses, wie im Stande der Technik üblich, nicht geerdet ist, steht dieses dann unter Spannung und stellt für Personen eine Gefahr dar.

Um ein gut auswertbares Signal zu erzeugen, können im Verkabelungsnetz einzelne aktive oder passive Bauelemente eingebaut sein, die als Signalmodulatoren arbeiten und das aufgeprägte Signal in Frequenz, Phase und Amplitude modulieren und weitersenden. Die vom Empfänger empfangenen Signale werden sodann als Signatur der PV-Anlagenkonfiguration in Form einer Sprungantwort des Systems oder als Interferenzmuster mit dem originalen Signal ausgewertet.

Um die Zuverlässigkeit der Mustererkennung in der Signalauswertung zu verbessern, können verschiedene Sender im Leitungsnetz verteilt sein, die ihrerseits mit ihnen zugeordneten Modulatoren kommunizieren und Sprungantworten bzw. Interferenzmuster registrieren und mit gespeicherten Mustern vergleichen. Die Ergebnisse werden dann über das Leitungsnetz an einen zentralen Empfänger versandt.

Der zuvor angesprochenen Gefährdung von Personen kann insbesondere dadurch begegnet werden, dass der Strom auf der Verbindung zwischen Erdpotential und dem einen Pol der Photovoltaikanlage detektiert wird. Überschreitet der Strom einen vorgegebenen Strom-Grenzwert (analog eines FI-Schutzschalters), so wird eben diese Verbindung aufgetrennt, um den Photovoltaikgenerator in einen potentialfreien, d. h. ungebundenen Zustand zu überführen. Die zuvor beschrieben Potentialverbindung gegenüber Erde fällt hierdurch weg, und es kann von einem für Menschen ungefährlichen Betriebszustand ausgegangen werden.

Gemäß einer weiteren Ausgestaltung ist daher vorgesehen, dass die Anlage einen Schalter aufweist, der bei einem zwischen den Photovoltaik-Generator und Erdpotential detektierten Strom oberhalb eines vorgegebenen Strom-Grenzwerts die Spannungsquelle von der Photovoltaikanlage abtrennt oder die Spannungsquelle vom Erdpotential trennt (Fig. 3).

Es folgt die Beschreibung zweier erfindungsgemäßer Ausführungsbeispiele, wobei zunächst noch einmal auf den Stand der Technik eingegangen wird. Es zeigen:
- Figur 1: das Schema einer potentialgebundenen Photovoltaikanlage nach dem Stand der Technik,
- Figur 2: das Schema einer potentialfreien Photovoltaikanlage nach dem Stand der Technik und
- Figur 3: das Schema einer Photovoltaikanlage mit angehobenem Potential

Für gleiche Bauelemente werden dieselben Bezugszeichen verwendet.

Wie erwähnt, ist in den Figuren 1 und 2 das Schema einer potential-gebundenen bzw. potentialfreien Photovoltaikanlage (PV-Anlage) 1 dargestellt. Hierauf wurde im einleitenden Teil bereits kurz eingegangen. Die PV-Anlage 1 umfasst eine Anzahl von Photovoltaikmodulen 3, im Folgenden kurz Module genannt, die miteinander in Reihe geschaltet sind. Die Module 3 bilden gemeinsam einen Strang 5, der elektrisch ein erstes Strangende 7 aufweist, welches den Minuspol des PV-Generators 6 darstellt und an welchem ein negatives Strangpotential P1 anliegt. Es können mehrere Stränge 5 parallel geschaltet sein. Der Strang 7 hat ein zweites Strangende 9, an welchem ein positives Strangpotential P2 anliegt. Die zwischen den Strangenden 7, 9 anliegende Spannung ist mit Uo bezeichnet. An den Strangenden 7, 9 liegt ein potentialfreier Wechselrichter 11 an, der den von den Modulen 3 gelieferten Gleichstrom in Wechselstrom wandelt und z.B. zur Einspeisung in ein Versorgungsnetz (nicht gezeigt) zur Verfügung stellt. Der Begriff "potentialfrei" besagt hier, dass der Wechselrichter 11 erdpotentialfrei ist, also nicht an Erde 13 gebunden ist: Er hat damit weder ein positive noch negative Verbindung zur Erde 13.

Gemäß Figur 1 ist die Photovoltaikanlage 1 potentialgebunden betrieben, d.h. das negative Strangpotential P1 am ersten Strangende 7 ist auf Erdpotential 13 gelegt. Das positive Strangpotential P2 ist dann gleich der über die Stränge 5 anliegenden Spannung Uo und entspricht im Leerlauf z.B. 800 Volt. Die in Figur 2 gezeigte Photovoltaikanlage 1 zeigt dagegen den potentialfreien Betrieb einer Photovoltaikanlage 1. An jedem der beiden Strangenden 7, 9 liegt ungefähr die gleiche Spannung an. Das positive Strangpotential P2 beträgt am Beispiel betrachtet dann ca. + 400 Volt gegen Erde 13, und das negative Strangpotential P1 beträgt ca. -400 Volt gegen Erde 13. Da die Luft kein perfekter Isolator ist, treten Elektronen aus den gegen Erde 13 mit Pluspotential behafteten Modulen 3a aus; sie treten in die gegen Erde 13 mit Minuspotential behafteten Module 3b ein. Dieses ist symbolisch durch die Pfeile 15a dargestellt. Dasselbe gilt für die Kathodenentladungen, die durch die Pfeile 17a symbolisiert sind.

In der Figur 3 ist neben den zuvor bezeichneten Bauteilen und Elementen 3 bis 13 eine Konstant-Gleich-Spannungsquelle 23 dargestellt, die im Ausführungsbeispiel eine Spannung von z. B. Uz = 1000 Volt liefert und einen Plus-Anschlusspol 27 und einen Minus-Anschlusspol 25 besitzt.

Diese 1000 Volt fixieren in Fig. 3 die Spannung am zweiten Strangspannungsende 9 auf ein positives Strangpotential P2 von eben diesen 1000 Volt, wobei das negative Strangpotential P1 floatet. Zieht man die über den Strang 5 anliegende Spannung Uo von Uz = 800 Volt ab, so ergibt sich ein Strangpotential P1 am ersten Strangende 7 von plus 200 Volt im Leerlauffall und von plus 500 Volt im Lastfall. Das Strangpotential P1 ist hier also positiv, was von besonderer Bedeutung ist. Das heißt, die gesamten PV-Module 3 liegen auf gegen Erde 13 positivem Potential, und die Elektronen werden von jedem positiven Modul 3 gegen Erde 13 abgeleitet.

Außerdem ist selbst das unten gezeichnete Modul 3 auf gegenüber Erde 13 positivem Potential. Damit ist die Blitz-Einschlaggefahr vermindert.

Es war erwähnt worden, dass die Vorrichtung 23 zur Potentialanhebung hier eine Konstant-Gleichspannungsquelle ist. Dabei ist festzuhalten: Je höher die Zusatzspannung Uz der Konstant-Spannungsquelle 23 ist, desto größer ist die Sicherheit gegen Blitzeinschlag.

Dieselben Effekte treten auch dann auf, wenn die Vorrichtung 23 eine Konstant-Gleichstromquelle ist.

Die in Fig. 3 dargestellte Anlage 1 beinhaltet auch Mittel zum Personenschutz in Form eines Schutzschalters 31 oder eines alternativen Schutzschalters 31A. Damit ist eine Person bei Berührung eines Teils der Anlage 1 geschützt. Der Schalter 31 bzw. 31A ist so angebracht, dass er beim Erreichen eines vorgegebenen Stromgrenzwerts i* die Konstantspannungsquelle 23 wegschaltet. D. h. fortan fließt kein Strom i mehr durch den Körper der gefährdeten Person. Der Stromwert i* für den maximal zulässigen Fehlerstrom i kann z. B. 20 mA betragen. Natürlich kann auch zusätzlich ein Alarmsignal a abgegeben werden.

Mit anderen Worten: Es ist zur Vermeidung der Gefährdung von Personen ein Schutzschalter 31 - oder alternativ ein Schutzschalter 31A - eingesetzt. Er dient dazu, an irgendeiner Stelle die Verbindung zwischen Erde 13 und dem einen Pol 27 der Gleichspannungsquelle 23 abzutrennen. Er hat die Funktion eines FI-Schutzschalters. Vorliegend wird jedoch nicht ein solcher Fehlerstrom-Schalter eingesetzt. Vielmehr liegt in der Leitung ein Sensor oder Strommessglied 33, das den Strom i misst und einen entsprechenden Messwert einem Vergleichsglied 35 zuführt. Dieses ist mit einem vorgebunden Strom-Grenzwert i* beaufschlagt. Übersteigt der Stromwert i den Grenzwert i*, so wird ein Abschaltsignal p abgegeben, das zum Abschalten des Schalters 31 bzw. 31A führt.

Dieses Abschaltsignal p kann gleichzeitig auch als Alarmsignal a dienen, um den gefährlichen Zustand der Anlage 1 oder die Gefährdung einer Person anzuzeigen.

### Bezugszeichenliste

- 1: Photovoltaikanlage
- 3, 3a, 3b: Photovoltaikmodul
- 5: Strang
- 6: Photovoltaik-Generator
- 7: 1. Strangende
- 9: 2. Strangende
- 11: Wechselrichter
- 13: Spannungsquelle
- 15a, 15b: Modul-zu-Modul-Entladungen
- 17a, 17b: Modul-zu-Erde-Entladungen
- 23: Spannungsquelle
- 25: Minus-Anschlusspol
- 27: Plus-Anschlusspol
- 29: Modul-zu-Erde-Entladungen
- 31: Schutzschalter
- 31A: alternativer Schutzschalter
- 33: Strommessglied oder-sensor
- 35: Vergleichsglied

- P1: negatives Strangpotential
- P2: positives Strangspotential
- Uo: Spannung des PV-Generators 6
- Uz: Zusatzspannung
- i: Strom
- p: Abschaltsignal
- i*: maximal zulässiger Strom
- a: Alarmsignal

## Patentansprüche

1. Photovoltaikanlage (1) mit einer Mehrzahl von Photovoltaik-Modulen (3), die elektrisch zu mindestens einem Strang (5) verbunden sind und so einen Photovoltaik-Generator (6) bilden, dessen erstes Strangende (7) einen Minuspol bildet und dessen zweites Strangende (9) einen Pluspol bildet, und mit einer Vorrichtung (23) zur Spannungsanhebung, mittels der das Potential (P2) des Pluspols gegenüber Erde (13) angehoben wird, wobei die Vorrichtung (23) eine Spannungsquelle mit einem Minus-Anschlusspol (25) und einem Plus-Anschlusspol (27) ist, und wobei der Minus-Anschlusspol (25) auf Erdpotential (13) gelegt ist und der Plus-Anschlusspol (27) elektrisch mit dem Pluspol des Photovoltaik-Generators (6) verbunden ist.

2. Photovoltaikanlage (1) nach Anspruch 1, **dadurch gekennzeichnet, dass** die Spannungsquelle (23) eine Konstant-Spannungsquelle mit vorgegebener Spannung (Uz) ist.

3. Photovoltaikanlage (1) nach Anspruch 1 oder 2, **dadurch gekennzeichnet, dass** das erste und das zweite Strangende (7, 9) des Photovoltaik-Generators (6) an einen potential-freien Wechselrichter (11) angeschlossen sind.

4. Photovoltaikanlage (1) nach Anspruch 2, 3 oder 4, **dadurch gekennzeichnet, dass** die Konstant-Spannungsquelle (23) eine Spannung (Uz) zwischen 150 Volt und 1500 Volt bereitstellt.

5. Photovoltaikanlage (1) nach einem der Ansprüche 1 bis 4, **dadurch gekennzeichnet, dass** ein Signal auf die Anschlusspole (27, 28) des Photovoltaik-Generators (6) aufgeprägt wird.

6. Photovoltaikanlage (1) nach einem der Ansprüche 2 bis 4 und Anspruch 5, **dadurch gekennzeichnet, dass** das aufgeprägte Signal mittels der Konstant-Spannungsquelle (23) aufgeprägt wird.

7. Photovoltaikanlage (1) nach einem der Ansprüche 2 bis 4 und Anspruch 5, wobei die Anlage (1) ein Kabelsystem besitzt, **dadurch gekennzeichnet, dass** das aufgeprägte Signal mit mindestens einem innerhalb des Kabelsystems verteilten aktiven oder passiven Bauelement moduliert wird.

8. Photovoltaikanlage (1) nach einem der Ansprüche 4 bis 7, **dadurch gekennzeichnet, dass** sich in ihr mindestens ein Empfänger zur Auswertung eines empfangenen, insbesondere des aufgeprägten oder eines reflektierten Signals befindet.

9. Photovoltaikanlage (1) nach Anspruch 8, **dadurch gekennzeichnet, daß** sich der mindestens eine Empfänger an den Anschlußpolen der Photovoltaik-Anlage (1) befindet.

10. Photovoltaikanlage (1) nach Anspruchen 8 oder 9, **dadurch gekennzeichnet, daß** der Empfänger das mindestens eine empfangene Signal nach Abweichungen von einem abgespeicherten Muster untersucht und bei Abweichungen ein Alarmsignal ausgibt.

11. Photovoltaikanlage (1) nach Anspruch 10, **dadurch gekennzeichnet, daß** das aufgeprägte Signal so gewählt ist, dass sich das empfangene Signal bei einer Änderung der Verschaltung der Photovoltaik-Anlage (1) ändert.

12. Photovoltaikanlage (1) nach einem der Ansprüche 8 bis 11, **dadurch gekennzeichnet, daß** der mindestens eine Empfänger digitale Signale von dem mindestens einen aktiven oder passiven Bauelement empfängt, in welchen Informationen über Verschaltungs- und Betriebszustände kodiert sind, so dass bei einer Verschaltungsabweichung ein Alarmsignal ausgegeben wird.

13. Photovoltaikanlage (1) nach einem der Ansprüche 10 bis 12, **dadurch gekennzeichnet, dass** das Alarmsignal an eine Alarmmeldezentrale weitergeleitet wird.

14. Photovoltaikanlage (1) nach einem der Ansprüche 10 bis 13, **dadurch gekennzeichnet, dass** das Alarmsignal an eine Warnvorrichtung weitergeleitet wird, welche den Betriebszustand der Photovoltaikanlage (1) und/oder den Gefährdungsgrad für Personen anzeigt.

15. Photovoltaikanlage (1) nach einem der Ansprüche 1 bis 14, **gekennzeichnet durch** einen Schalter (31, 31A), der bei einem zwischen dem Photovoltaik-Generator (6) und Erdpotential (13) detektierten Strom (i) oberhalb eines vorgegebenen Strom-Grenzwerts (i*) die Spannungsquelle (23) von der Photovoltaikanlage (1) abtrennt oder die Spannungsquelle (23) vom Erdpotential (13) trennt.

## Claims

1. Photovoltaic plant (1) with several photovoltaic modules (3), which are electrically arranged to at least one string (5) and thus build a photovoltaic generator(6), whose first end of string (7) builds a negative pole and whose second end of string (9) builds a positive pole, and with a device (23) for increasing voltage, whereby the potential (P2) of the positive pole is increased to earth (13), whereby the device (23) is a supply point with a negative terminal (25) and a positive terminal (27), and whereby the negative terminal (25) is connected to earth potential (13) and the positive terminal (27) is electrically connected to the positive pole of the photovoltaic generator (6).

2. Photovoltaic plant (1) as defined in claim 1, and **characterized in that** the supply point (23) is a constant supply point with a preset voltage (Uz).

3. Photovoltaic plant (1) as defined in claim 1 or 2, and **characterized in that** the first and the second end of string (7, 9) of the photovoltaic generator (6) are connected to a potential-free inverter (11).

4. Photovoltaic plant (1) as defined in claim 2, 3 or 4, and **characterized in that** the constant voltage source (23) provides a voltage (Uz) between 150 volt and 1500 volt.

5. Photovoltaic plant (1) as defined in one of the claims 1 to 4, **characterized in that** a signal is impressed on the terminals (27, 28) of the photovoltaic generator (6).

6. Photovoltaic plant (1) as defined in one of the claims 2 to 4, and claim 5, **characterized in that**, that the impressed signal is impressed via the constant voltage source (23).

7. Photovoltaic plant (1) as defined in one of the claims 2 to 4 and claim 5, whereby the plant (1) has a cable system, **characterized in that** the impressed signal is modulated by at least one active or passive structural element distributed within the cable system.

8. Photovoltaic plant (1) as defined in one of the claims 4 to 7, and **characterized in that**, there is situated in it at least one receiver for evaluating a received - in particular the impressed signal - or a reflected signal.

9. Photovoltaic plant (1) as defined in claim 8, **characterized in that** at least the one receiver is situated at the terminals of the photovoltaic plant (1).

10. Photovoltaic plant (1) as defined in claims 8 or 9, **characterized in that** the receiver checks the at least one received signal regarding deviations from a stored pattern and gives alarm in the event of deviations.

11. Photovoltaic plant (1) as defined in claim 10, **characterized in that** the impressed signal is selected so, that the impressed signal changes in case of a change of the connection of the photovoltaic plant (1).

12. Photovoltaic plant (1) as defined in one of the claims 8 to 11, **characterized in that** the at least one receiver receives digital signals from the at least one active or passive structural member, wherein information is coded about connection-and operating conditions, so that in case of a deviation of the connection an alarm is given.

13. Photovoltaic plant (1) as defined in one of the claims 10 to 12, **characterized in that** the alarm is routed to an alarm control unit.

14. Photovoltaic plant (1) as defined in one of the claims 10 to 13, **characterized in that** the alarm is routed to a warning device, which indicates the operating condition of the photovoltaic plant (1) and/or the exposure to persons.

15. Photovoltaic plant (1) as defined in one of the claims 1 to 14, **characterized in that** a switch (31, 31A), which concerning a detected current (i) above a preset limit value (i*) between the photovoltaic generator (6) and the earth potential (13) separates the supply point ((23) from the photovoltaic plant (1) or the supply point (23) from the earth potential.

## Revendications

1. Dispositif photovoltaïque (1) comprenant une pluralité de modules photovoltaïques connectés électriquement à au moins une ligne (5), formant ainsi un générateur photovoltaïque (6), la première extremité (7) de la ligne formant un pôle négatif et la deuxième extremité (9) formant un pôle positif, et comprenant un dispositif (23) pour augmenter la tension par lequel le potentiel (P2) du pôle positif par rapport à la terre (13) est augmenté, ce dispositif (23) étant une source de tension avec un pôle négatif de connexion (25) et un pôle positif de connexion (27), le pôle négatif de connexion (25) étant relié au potentiel de terre (13) et le pôle positif de connexion (27) étant joint au pôle positif du générateur photovoltaïque (6).

2. Dispositif photovoltaïque (1) selon la revendication 1, **caractérisé en ce que** la source de tension (23) est une source de tension constante avec une tension prédéterminée.

3. Dispositif photovoltaïque (1) selon la revendication 1 ou 2, **caractérisé en ce que** les première et deuxième extremités (7, 9) du générateur photovoltaïque (6) sont raccordées à un ondulateur (11) libre dépourvu de potentiel.

4. Dispositif photovoltaïque (1) selon la revendication 2, 3 ou 4, cractérisé en ce que la source de tension constante (23) fournit une tension (Uz) entre 150 volt et 1500 volt.

5. Dispositif photovoltaïque (1) selon une des revendications 1 à 4, **caractérisé en ce qu'**un signal est appliqué aux pôles de connexion (27, 28) du générateur photovoltaïque (6).

6. Dispositif photovoltaïque (1) selon une des revendications 2 à 4 et 5, **caractérisé en ce que** le signal appliqué est appliqué par la source de tension constante (23).

7. Dispositif photovoltaïque (1) selon une des revendications 2 à 4 et 5, le dispositif possédant un système de câbles, **caractérisé en ce que** le signal appliqué est modulé par au moins un élément actif ou passif distribué au sein du système de câbles.

8. Dispositif photovoltaïque (1) selon une des revendications 4 à 7, **caractérisé en ce que** se trouve au sein de celui-ci au moins un récepteur pour l'évaluation d'un signal reçu, notamment du signal appliqué ou d'un signal reflété.

9. Dispositif photovoltaïque (1) selon la revendication 8, **caractérisé en ce que** l'au moins un récepteur se trouve aux pôles de connexion du dispositif photovoltaïque (1).

10. Dispositif photovoltaïque (1) selon les revendications 8 ou 9, **caractérisé en ce que** le récepteur analyse le signal reçu pour détecter des déviations par rapport à un signal modèle enregistré, et délivre un signal d'alarme en cas de déviations.

11. Dispositif photovoltaïque (1) selon la revendication 10, **caractérisé en ce que** le signal appliqué est choisi de façon que le signal reçu change lors d'un changement de la mise en circuit du dispositif photovoltaïque (1).

12. Dispositif photovoltaïque (1) selon une des revendications 8 à 11, **caractérisé en ce que** l'au moins un récepteur reçoit des signaux digitaux de l'au moins un élément actif ou passif dans lesquels sont codées des informations concernant les états de la mise en circuit et du foncionnement, de façon qu'un signal d'alarme est donné lors d'une déviation de la mise en circuit.

13. Dispositif photovoltaïque (1) selon une des revendications 10 à 12, **caractérisé en ce que** le signal d'alarme est transmis à un centre de signalisation d'alarme.

14. Dispositif photovoltaïque (1) selon une des revendications 10 à 13, **caractérisé en ce que** le signal d'alarme est transmis à un dispositif d'avertissement indiquant l'état de fonctionnement du dispositif photovoltaïque (1) et/ou le degré de risque pour des personnes.

15. Dispositif photovoltaïque (1) selon une des revendications 1 à 14, **caractérisé par** un interrupteur (31, 31A) séparant la source de tension (23) du dispositif photovoltaïque (1) ou séparant la source de tension (23) du potentiel de terre (13) au cas où un courant (i) au dessus d'une valeur limite de courant donnée (i*) est détecté entre le générateur photovoltaïque (6) et le potentiel de terre (13).
